# EUROPEAN PATENT APPLICATION

(11) **EP 4 683 435 A1**
(43) Date of publication of application: **21.01.2026**
(21) Application number: 24188736.3
(22) Date of filing: 16.07.2024
(51) Int. Cl.: H05K 1/14, H05K 1/02, H05K 1/16

(54) **ELECTRICAL CIRCUIT WITH A BYPASS COMPONENT FOR REDUCING ELECTROMAGNETIC EMISSION**

(71) Applicant: Bayerische Motoren Werke Aktiengesellschaft, 80809 München (DE)
(72) Inventor: Greuet, Jean-Baptiste, 85635 Höhenkirchen (DE); Schultheiss, Friedrich, 80993 München (DE); Iosava, Sofia, 80636 München (DE)

(57) **Abstract**

The present document describes an electrical circuit which comprises a disturbing component which generates a disturbance current during operation of the electrical circuit. Furthermore, the electrical circuit comprises a bypass component which is located in a direct vicinity of the disturbing component and which is configured to provide a path for the disturbance current that leads the disturbance current back to the disturbing component, such that the disturbing component and the bypass component form a current loop for the disturbance current.

## Description

The present document is directed at reducing the intensity of electromagnetic emission of an electrical circuit, e.g., of an electrical circuit of a vehicle.

A vehicle, notably a battery electric vehicle, comprises one or more electrical, notably electronic, circuits which typically produce electromagnetic emission during operation of the vehicle. The electromagnetic emission of an electronic module may be subjected to legal requirements, notably with respect to the maximum allowed intensity of the electromagnetic emission.

The present document is directed at the technical problem of reducing the electromagnetic emission of a component of an electrical circuit in an efficient and reliable manner. The technical problem is solved by the independent claim. Preferred examples are specified in the dependent claims.

According to an aspect, an electrical circuit is described, wherein the electrical circuit comprises a disturbing component which generates a disturbance current during operation of the electrical circuit. The disturbing component may comprise or may be a power module, notably a power switch such as a MOSFET or an IGBT. The disturbing component may be operated at a certain switching frequency. The disturbance current may comprise an alternating current at a disturbance frequency. The disturbance frequency may be dependent on the switching frequency of the disturbing component. The disturbance frequency may e.g. be 10MHz or more.

Furthermore, the electrical circuit comprises a bypass component which may be located in the direct vicinity of the disturbing component (e.g., directly next to the disturbing component) and which may be configured to provide a (return) path for the disturbance current that leads the disturbance current back to the disturbing component, such that the disturbing component and the bypass component form a (defined and/or additional) current loop for the disturbance current. The bypass component may exhibit a frequency-dependent impedance with a local minimum at the disturbance frequency. In a preferred example, the bypass component comprises a capacitor.

Hence, an electrical circuit is described which makes use of a bypass component to create an (additional and/or a defined) current loop (also referred to as a current return loop) for the disturbance current, such that the disturbance current is confined to the direct vicinity of the disturbing component, thereby reducing the electromagnetic emission which is generated by the electrical circuit (in comparison with a circuit that does not comprise such a defined current (return) loop).

The bypass component may comprise a dissipating element, in particular a resistor, which is configured to convert a part of the disturbance current into heat. The dissipating element may be arranged in series with the capacitor of the bypass component. The dissipating element may be configured to damp any further and/or possible (possibly unexpected) resonances. By making use of a dissipating element, the electromagnetic emission of the electrical circuit may be reduced further.

The electrical circuit may comprise a filter unit which is configured to block the disturbance current from flowing out of the (additional and/or defined) current loop. The filter unit may exhibit a frequency-dependent attenuation and/or impedance with a local maximum at the disturbance frequency. Hence, a filter unit may be used to confine the disturbance current within the (defined and/or additional) current loop, thereby further reducing the electromagnetic emission.

The electrical circuit may comprise a printed circuit board (PCB), wherein the disturbing component is located on a first side (e.g., the top side) of the printed circuit board. In particular, the disturbing component may be galvanically coupled to the first (electrically conducting) PCB layer (e.g., the top PCB layer) on the first side of the PCB. Furthermore, the electrical circuit may comprise an electrically conducting auxiliary layer, notably an electrically conducting (possibly metallic) auxiliary plate, which is located at the second side of the printed circuit board (which is opposite to the first side of the PCB). The PCB may comprise a second (electrically conducting) PCB layer (e.g. a bottom PCB layer) on the second side of the PCB (wherein the second side may also be referred to as the bottom side of the PCB). The auxiliary layer, notably the auxiliary plate, is preferably different and/or separate from the second PCB layer on the second side. The auxiliary layer, notably the auxiliary plate, may be positioned at a certain distance from the second side (notably from the second PCB layer at the second side) of the PCB. An electrically isolating layer (e.g., a thermal interface layer) may be located between the second side (notably between the second PCB layer on the second side) of the printed circuit board and the auxiliary layer.

The first node of the bypass component may be galvanically coupled (directly) to a node of the disturbing component. By way of example, both nodes may be galvanically coupled to the first PCB layer of the PCB. The second node of the bypass component may be galvanically coupled to the auxiliary layer, notably via a bypass connection. By doing this, the defined and/or additional (return) current loop may be provided in a particularly efficient and reliable manner (with low impedance and/or with low magnetic coupling).

The electrical circuit may comprise an, electrically conducting, reference layer. The reference layer may be part of the housing of the electrical circuit and/or may be coupled to ground. The electrical circuit may be placed within the housing, and/or the housing may (fully) encompass the electrical circuit.

Furthermore, the electrical circuit may comprise a further electrically isolating layer (e.g., a further thermal interface layer) which is located between the auxiliary layer and the reference layer. In addition, the electrical circuit may comprise one or more electrically conducting elements which galvanically connect the auxiliary layer with the reference layer. The one or more electrically conducting elements may each comprise a screw, which is configured to mechanically attach the auxiliary layer to the reference layer. Alternatively, or in addition, an electrically (notably galvanically) conducting element may be and/or may comprise a conducting foam and/or a conducting spring.

The reference layer and the auxiliary layer may form and/or may act as a (typically parasitic) capacitance, and the one or more electrically conducting elements may form and/or may act as an (typically parasitic) inductance. The (parasitic) capacitance and the (parasitic) inductance may be arranged in parallel to one another and may form and/or may act as the filter unit which is configured to block the disturbance current from flowing out of the current loop and/or to block the disturbance current from flowing to the reference layer. Hence, the filter unit may be implemented in an efficient and reliable manner (using one or more parasitic elements, notably capacitances and/or inductances).

The (parasitic) capacitance of the reference layer and the auxiliary layer and/or the (parasitic) inductance of the one or more electrically conducting elements may be designed and/or tuned such that the resulting filter unit exhibits a frequency-dependent attenuation and/or impedance with a local maximum at the disturbance frequency. Hence, one or more parasitic elements may be used to design a filter unit which blocks the disturbance current from flowing out of the (additional and/or defined) current loop.

Overall, the electrical circuit may comprise a PCB (with a first PCB (e.g., copper) layer on the first side and a second PCB (e.g., copper) layer on the second side). Furthermore, the electrical circuit may comprise an electrically conducting (e.g., metallic) auxiliary layer which is separated from the second PCB layer of the PCB via an electrically (notably galvanically) isolating layer. Furthermore, the electrical circuit may comprise a (e.g. metallic) reference layer which is separated from the auxiliary layer via a further electrically (notably galvanically) isolating layer.

The disturbing component may be galvanically connected to the first PCB layer of the PCB. Furthermore, the bypass component may be galvanically connected to the first PCB layer of the PCB. The bypass component may form a path for the disturbance current to the auxiliary layer, thereby providing the defined and/or additional current loop.

The electrical circuit which is described in the present document allows the disturbance current that is injected into the reference layer (e.g., ground) to be reduced. As a result of this, one or more Y-capacitors and/or filter components of the electrical circuit may be reduced or removed, thereby reducing the size and/or the cost of the electrical circuit.

It should be noted that the systems including its preferred embodiments as outlined in the present patent application may be used stand-alone or in combination with the other systems disclosed in this document. Furthermore, all aspects of the systems outlined in the present patent application may be arbitrarily combined. In particular, the features of the claims may be combined with one another in an arbitrary manner. Furthermore, it is noted that brackets are used within the present document to indicate optional features.

The invention is explained below in an exemplary manner with reference to the accompanying drawings, wherein
Fig. 1 shows an example electrical circuit of a vehicle;
Figs. 2a to 2c illustrate electrical circuits with different means for reducing EM emission;
Fig. 3 a shows a circuit diagram of an electrical circuit with components for reducing EM emission; and
Fig. 3b illustrates the output impedance and/or attenuation of a filter unit as a function of the frequency of the disturbance current (which generates the EM emission).

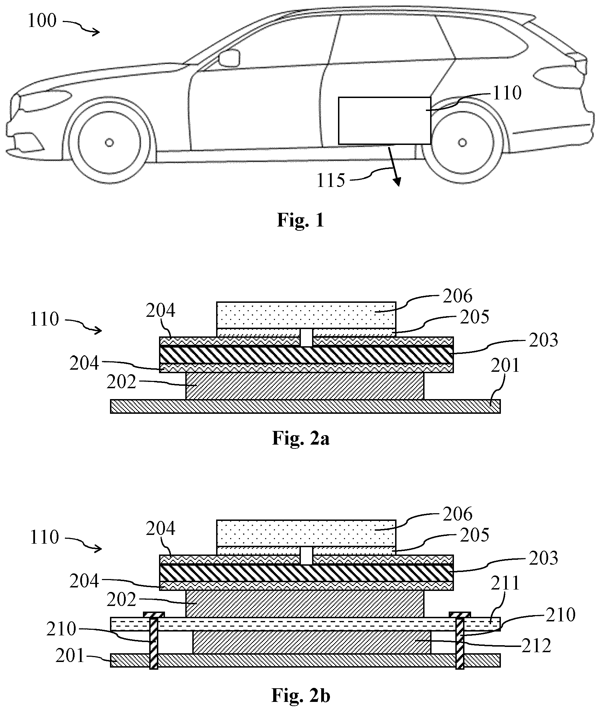

As outlined above, the present document is directed at reducing the electromagnetic (EM) emission of an electrical circuit in an efficient and reliable manner. In this context, Fig. 1 shows a vehicle 100 which comprises an electrical circuit 110. An example circuit 110 is an inverter which is configured to generate a multi-phase alternating current for operating an electrical motor of the vehicle 100 based on a direct current which is provided by a battery of the vehicle 100. Example components of the electrical circuit 110 are power switches, such as MOSFETs or IGBTs.

The electrical circuit 110 produces electromagnetic emission 115 (notably conducted and/or radiated emission) during operation of the circuit 110, wherein the electromagnetic emission 115 of the circuit 110 is typically a combination of the individual electromagnetic emission which is produced by the different components of the circuit 110.

Fig. 2a shows details of an example circuit 110. The circuit 110 comprises a printed circuit board (PCB) 203, 204 with one or more electrically conducting PCB layers 204, notably copper layers. The PCB 203, 204 may be attached to a housing (i.e. to a reference layer) 201 via a thermal interface layer 202 (i.e. via an isolating layer). Furthermore, the circuit 110 comprises one or more electronic components 206, such as a power switch, which are electrically coupled with a PCB layer 204 of the PCB 203, e.g. via an electrically conducting material 205 (such as solder). The one or more components 206 may be referred to as disturbing components.

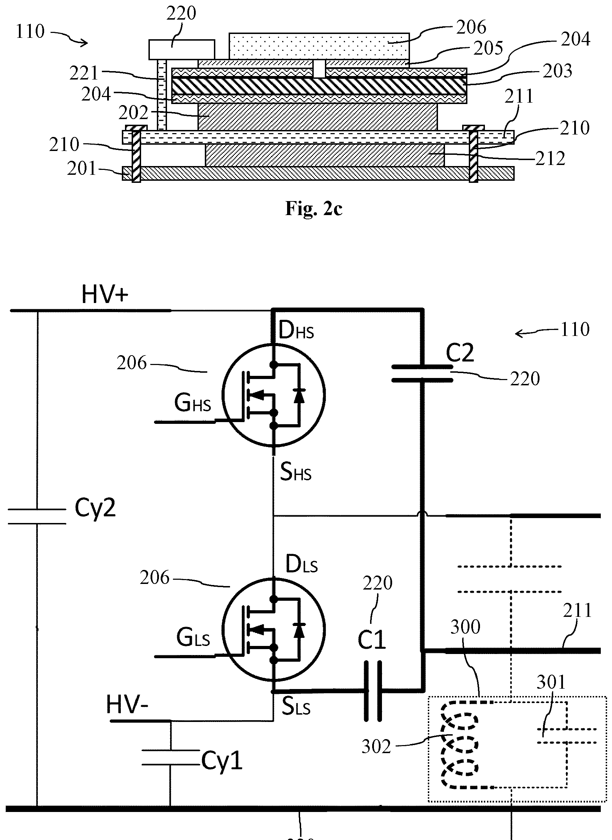

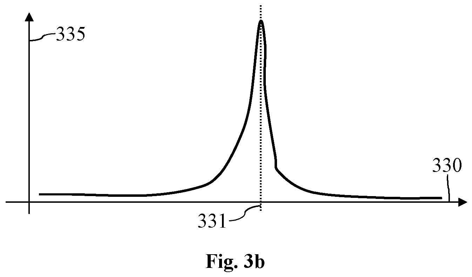

Fig. 3 a shows an example circuit diagram of a circuit 110 which comprises one or more disturbing components 206. The housing 201 of the circuit 110 shown in Fig. 2a may be (galvanically) connected to and/or may correspond to ground 320 (shown in Fig. 3a). The arrangement of the PCB 203, 204 and the housing 201, which are separated by a thermal interface layer 202, (as shown in Fig. 2a) form one or more parasitic capacitances. As a result of this, a disturbance current may be generated during operation of the circuit 110, which circulates within the circuit 110 (passing via ground 320 of the circuit 110 and/or passing via the switched node of the power switches (which are marked as S_{HS} and D_{LS}). This disturbance current may comprise (a frequency component at) a certain disturbance frequency, wherein the disturbance frequency may be dependent on the switching frequency of the one or more disturbing components 206 of the circuit 110, on the value of the one or more Y-capacitors Cy1, Cy2 and/or on the slew rate of the switching transition. The disturbance current may generate EM emission.

As illustrated in Fig. 3a, a filter unit 300 may be added to the circuit 110, wherein the filter unit 300 is configured to block and/or prevent the disturbance current from flowing towards ground 320. Fig. 3b shows an attenuation and/or impedance diagram of the filter unit 300. In particular, an (electrically conducting) auxiliary layer may be added to the circuit 110 (as outlined in the context of Figs. 2b and 2c), which may be used to provide a filter unit 300 (wherein the filter unit 300 comprises one or more parasitic capacitances 301 and/or parasitic inductances 302).

Fig. 3b shows the impedance and/or attenuation 335 of the filter unit 300, as a function of frequency 330. The impedance and/or attenuation 335 may exhibit a peak at the disturbance frequency 331 of the disturbance current, thereby preventing the disturbance current from flowing to ground 320 in an effective manner.

Furthermore, the circuit 110 may comprise one or more bypass components 220, which provide a bypass for the disturbance current, such that the disturbance current flows through the one or more disturbing components 206 and through the one or more bypass components 220. Hence, the disturbance current may be restricted to flow within a (defined) current loop in a relatively small area around the one or more components 206, thereby reducing the extent of the EM emission 115.

Fig. 2b shows an example implementation of the filter unit 300 within the circuit 110 of Fig. 2a. The circuit 110 comprises an electrically conducting auxiliary plate 211 which is arranged between the PCB 203, 304 and the housing 201. The auxiliary plate 211 (or more generally the auxiliary layer) is electrically isolated from the PCB 203, 204 using the thermal interface layer 202 (or more generally the electrically isolating layer 202). Furthermore, the auxiliary plate 211 is electrically isolated from the housing 201 using another thermal interface layer 212 (i.e., another electrically isolating layer). As a result of this, the auxiliary plate 211 forms a (parasitic) capacitance 301 of the filter unit 300.

The auxiliary plate 211 may be mechanically attached (and electrically coupled) to the housing 201 using one or more, electrically conducting, screws 210. The one or more screws 210 form and/or act as an (parasitic) inductance 302 of the filter unit 300, which is arranged in parallel to the (parasitic) capacitance 301 of the filter unit 300. The one or more screws 210 and/or the auxiliary plate 211 may be designed such that the resulting filter unit 300 exhibits a peak of the impedance and/or attenuation 335 at the disturbance frequency 331 of the disturbance current.

The circuit 110 of Fig. 2c further comprises a bypass component 220, which is preferably placed in direct vicinity of the disturbing component 206 of the circuit 110. The bypass component 220 may comprise a capacitor C1, C2. The first node of the bypass component 220 may be electrically (notably galvanically) coupled (directly) with a node of the electronic component 206, and the second node of the bypass component 220 may be electrically (notably galvanically) coupled to the auxiliary plate 211 via an, electrically (notably galvanically) conducting, bypass connection 221. In particular, the first node of the bypass component 220 may be (galvanically) coupled to the quiet node (e.g., D_{HS} or S_{LS} in Fig. 3a) of the disturbing component 206. The quite node may be the node of the disturbing component 206, which is maintained at a substantially constant potential (e.g., HV+ or HV-).

As a result of this, a (defined) current loop for the disturbance current may be provided, which is confined to the direct vicinity of the disturbing component 206, thereby reducing the EM emission 115 of the circuit 110 in a particularly reliable and efficient manner.

Hence, a passive (bypass) component 220 (for example a capacitor) may be placed closely to the power module and/or noise source 206. The (bypass) component 220 may be (galvanically) connected to the quiet node and/or the quite potential of the power module and/or noise source 206. The (bypass) component 220 may act as a low impedance path that diverts the disturbance current from flowing through a parasitic capacitor towards ground 320 (wherein the parasitic capacitor is shown in a dotted manner above the filter unit 300 in Fig. 3a).

Furthermore, one or more screws 210 (forming a parasitic inductance 302) may be used in conjunction with an auxiliary conductive plate 211 (forming a parasitic capacitance 301) to create a high impedance path that prevents the noise propagation to a part of the circuit 110 (e.g., to ground 320), which is to be avoided. The capacitor of the bypass component 220 may be placed in series with another element (e.g., a resistor to dissipate a part of the noise energy via heat). The capacitor of the bypass component 220 is preferably placed physically as close as possible to the power module 206. The value of this capacitor may be chosen (or tuned) to provide a low impedance path at the one or more disturbance frequencies 331 of the EM emission 115. This path diverts the Common Mode (CM) noise from its "usual" coupling path and leads it directly back to its source.

Hence, a metal (or conductive) intermediate plate 211 may be placed between an existing metal plate 201 and a switching module 206, while maintaining a certain distance between the module 206, the intermediate plate 201 and the existing plate 201. The intermediate plate 206 may be screwed to the existing metal plate 201. Furthermore, a filtering (bypass) component 220 may be soldered between the intermediate plate 211 and the quiet potential of the switching module 206.

In Fig. 2c, an example of a transistor 206 is shown, which is soldered on a PCB 203, wherein the PCB 203 is connected to a cooling plate 201. The disturbance frequency 331 may be at 50MHz. A tuned capacitor 220 with a sufficiently high voltage "solidity" (for example 200V or higher, for an AC and/or DC voltage) may be soldered to one side of the transistor 206. One node of the capacitor 220 may be connected to the intermediate plate (i.e. to the auxiliary layer) 211, and the other node of the capacitor 220 may be connected to the quiet potential of the transistor 206.

It should be noted that the description and drawings merely illustrate the principles of the proposed systems. Those skilled in the art will be able to implement various arrangements that, although not explicitly described or shown herein, embody the principles of the invention and are included within its spirit and scope. Furthermore, all examples and embodiment outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

## Claims

1. An electrical circuit (110), wherein the electrical circuit (110) comprises,
- a disturbing component (206) which generates a disturbance current during operation of the electrical circuit (110); and
- a bypass component (220) which is located in a direct vicinity of the disturbing component (206) and which is configured to provide a path for the disturbance current that leads the disturbance current back to the disturbing component (206), such that the disturbing component (206) and the bypass component (220) form a current loop for the disturbance current.

2. The electrical circuit (110) of claim 1, wherein the bypass component (220) comprises a capacitor.

3. The electrical circuit (110) of any previous claim, wherein the bypass component (220) comprises a dissipating element, in particular a resistor, which is configured to convert a part of the disturbance current into heat.

4. The electrical circuit (110) of any previous claim, wherein
- the disturbance current comprises an alternating current at a disturbance frequency (331); and
- the bypass component (220) exhibits a frequency-dependent impedance with a local minimum at the disturbance frequency (331).

5. The electrical circuit (110) of any previous claim, wherein the electrical circuit (110) comprises a filter unit (300) which is configured to block the disturbance current from flowing out of the current loop.

6. The electrical circuit (110) of claim 5, wherein
- the disturbance current comprises an alternating current at a disturbance frequency (331); and
- the filter unit (300) exhibits a frequency-dependent attenuation (335) and/or impedance with a local maximum at the disturbance frequency (331).

7. The electrical circuit (110) of any previous claim, wherein the electrical circuit (110) comprises
- a printed circuit board (203); wherein the disturbing component (206) is located on a first side of the printed circuit board (203);
- an electrically conducting auxiliary layer (211), notably an electrically conducting auxiliary plate, which is located at a second side of the printed circuit board (203); and
- an electrically isolating layer (202) which is located between the second side of the printed circuit board (203) and the auxiliary layer (211); wherein a first node of the bypass component (220) is electrically coupled to a node of the disturbing component (206), and wherein a second node of the bypass component (220) is electrically coupled to the auxiliary layer (211), notably via a bypass connection (221).

8. The electrical circuit (110) of claim 7, wherein the electrical circuit (110) comprises
- a, electrically conducting, reference layer (201);
- a further electrically isolating layer (212) which is located between the auxiliary layer (211) and the reference layer (201); and
- one or more electrically conducting elements (210) which couple the auxiliary layer (211) electrically with the reference layer (201).

9. The electrical circuit (110) of claim 8, wherein an electrically conducting element (210) comprises a screw, which is configured to mechanically attach the auxiliary layer (211) to the reference layer (201).

10. The electrical circuit (110) of any of claims 8 to 9, wherein the reference layer (201) is part of a housing of the electrical circuit (110) and/or is coupled to ground (320).

11. The electrical circuit (110) of any of claims 8 to 10, wherein
- the reference layer (201) and the auxiliary layer (211) form a capacitance;
- the one or more electrically conducting elements (210) form an inductance; and
- the capacitance and the inductance are arranged in parallel to one another and form a filter unit (300) which is configured to block the disturbance current from flowing out of the current loop and/or to block the disturbance current from flowing to the reference layer (201).
